# EUROPÄISCHE PATENTSCHRIFT

(11) **EP 0 838 688 B1**
(45) Veröffentlichungstag und Bekanntmachung des Hinweises auf die Patenterteilung: **08.08.2007**
(21) Anmeldenummer: 97118640.8
(22) Anmeldetag: 27.10.1997
(51) Int. Cl.: G01R 31/28

(54) **Vorrichtung und Verfahren zum Prüfen von Leiterplatten**
Device and procedure for testing printed circuit boards
Appareil et procédé de test de circuits imprimés

(30) Priorität: 28.10.1996 DE 19644725; 02.05.1997 DE 19718637
(43) Veröffentlichungstag der Anmeldung: 29.04.1998
(73) Patentinhaber: atg test systems GmbH, 97877 Wertheim/Reicholzheim (DE)
(72) Erfinder: Prokopp, Manfred, 97877 Wertheim-Reicholzheim (DE)
(74) Vertreter: Ganahl, Bernhard

(56) Entgegenhaltungen:
- EP-A- 0 448 483
- EP-A- 0 636 895
- WO-A-95/23341
- DE-A- 19 507 127
- FR-A- 2 608 775
- US-A- 5 457 380

## Beschreibung

Die Erfindung betrifft eine Vorrichtung und ein Verfahren zum Prüfen von Leiterplatten.

Leiterplatten weisen eine Vielzahl von Netzen auf, wobei deren Dichte auf den Leiterplatten sich mit der kontinuierlich fortschreitenden Miniaturisierung der elektronischen Bauelemente zunehmend erhöht.

Bekannte Vorrichtungen zum Prüfen von Leiterplatten können grundsätzlich in zwei Gruppen eingeteilt werden. Zur ersten Gruppe gehören die Vorrichtungen mit Adapter, bei welchen alle Leiterplattentestpunkte einer Leiterplatte gleichzeitig mittels des Adapters kontaktiert werden. Die zweite Gruppe umfaßt die sogenannten Fingertester. Das sind Vorrichtungen, die mit zwei oder mehreren Prüffingern die einzelnen Leiterplattentestpunkte sequentiell abtasten.

Prüfvorrichtungen mit Adapter gehen bspw. aus der DE 42 37 591 A1, der DE 44 06 538 A1, der DE 43 23 276 A, der EP 215 146 B1 und der DE 38 38 413 A1 hervor.

Derartige Adapter dienen grundsätzlich dazu, die ungleichmäßige Konfiguration der Leiterplattentestpunkte der zu testenden Leiterplatte an das vorgegebene Grundraster der elektrischen Prüfvorrichtung anzupassen. Bei modernen, zu testenden Leiterplatten sind die Leiterplattentestpunkte nicht mehr in einem gleichmäßigen Raster angeordnet, weshalb die die Verbindung zwischen dem Kontaktraster und den Leiterplattentestpunkten herstellenden Kontaktnadeln im Adapter mit einer Schrägstellung bzw. Auslenkung angeordnet sind oder ein sogenannter Translator vorgesehen ist, der das gleichmäßige Kontaktraster in die ungleichmäßige Konfiguration der Leiterplattentestpunkte "übersetzt".

Unabhängig von der Art der Vorrichtung werden die einzelnen Netze auf Unterbrechungen in den Netzen ("Unterbrechungstest") und auf elektrische Verbindungen zu anderen Netzen ("Kurzschlußtest") getestet. Der Kurzschlußtest kann sowohl die Detektion von niederohmigen als auch von hochohmigen Verbindungen umfassen.

Sowohl für den Unterbrechungstest als auch für den Kurzschlußtest sind unterschiedliche Meßverfahren bekannt. Hierbei wird jedes Netz auf einen Kurzschluß bzw. jeder Zweig eines Netzes auf eine Unterbrechung untersucht, so daß bei modernen Leiterplatten mit einer Vielzahl von Netzen eine entsprechend hohe Anzahl einzelner Meßvorgänge durchgeführt werden muß.

Man hat versucht, die einzelnen Meßvorgänge zu optimieren und deren Anzahl zu minimieren, wobei eine Vielzahl unterschiedlicher Verfahren vorgeschlagen und umgesetzt worden sind.
Die DE 195 07 127 A1 offenbart ein Adaptersystem für Baugruppen-Platinen, zur Verwendung in einer Prüfeinrichtung. Sie weist eine Rasterplatte auf, die an ihrer zum Prüfling weisenden Oberfläche Kontaktstellen mit einem regelmäßigen Raster besitzt. Einige der Kontaktflächen sind elektrisch miteinander verbunden. Hierdurch kann jedem Testkanal der Prüfeinrichtung jeweils eine n-fache Anzahl Kontaktflächen auf der Rasterplatte zugeordnet sein. Durch die Schrägstellung eines Federkontaktstiftes ist es möglich, dass eine Prüfstelle an der Baugruppen-Platine mit mehreren, zum Beispiel an neuen Kontaktstellen kontaktiert werden kann. Ist eine Kontaktstelle mit einem Testkanal verbunden, der bereits besetzt ist, wird eine andre Kontaktstelle bzw. Kontaktfläche ausgewählt

Aus der US 5,457,380 geht eine Prüfvorrichtung zum Testen von bestückten Leiterplatten hervor, bei welcher im Adapter mehrere Prüfstifte auf den gleichen Anschlusspunkt zur Auswertung der Elektronik gesetzt sind, um zu prüfende Testpunkte der zu testenden Leiterplatte elektrisch miteinander zu verbinden.

Aus der WO 95/23341 geht ein Adapter zum Prüfen von Leiterplatten hervor, der ein Grundraster einer Prüfvorrichtung mit Leiterplattentestpunkten einer zu prüfenden Leiterplatte verbindet. Dieser Adapter weist für Bereiche, an welchen die Leiterplattentestpunktdichte höher ist als die reguläre Dichte von Kontaktpunkten des Adapters ein sogenanntes Expansionsmodul auf, das ein kleiner, zusätzlich in dem bestehenden Adapter integrierter Adapter ist. Dieses Expansionsmodul weist eine höhere Dichte an Kontaktstiften im Vergleich zum übrigen Adapter auf. Da die zusätzlichen Kontaktstifte nicht mit dem Grundraster verbunden werden können, da diese bereits vollständig belegt sind, sind zusätzliche Leitungen von Expansiosmodulen vorgesehen, die direkt zur Testelektronik führen. Diese zusätzlichen Leitungen sind als biegsame Kabel ausgebildet.

Aus der EP 0 448 481 A1 ist die Verwendung von Translator bekannt, um eng nebeneinander liegende Leiterplattentestpunkte auf ein Raster zu transformieren, bei dem die Abstände der Kontakte größer sind und das dann von einem Adapter leichter kontaktierbar ist.

Die US 4,774,462 offenbart einen Paralleltester zum Testen von sowohl bestückten als auch unbestückten Leiterplatten. Dieser Paralleltester ist zum Testen von Leierplatten ausgebildet, deren Kontaktstellen in einem Raster von 0,1 Zoll angeordnet sind. Diese Testvorrichtung ist auch lediglich zum einseitigen Testen der Leiterplatten ausgebildet. Diese Prüfvorrichtung weist ein Grundraster mit 50 Kontaktstellen pro Quadratzoll auf, wobei die Kontaktstellen paarweise miteinander elektrisch verbunden sind. Die Verbindung zwischen den Kontaktstellen untereinander und von den Kontaktstellen zu Auswerteelektronik erfolgt mittels von Hand verlegter Leitungen. Auf diesem Grundraster ist ein Adapter mit schräg gestellten Federkontaktstiften angeordnet.

Der Erfindung liegt die Aufgabe zugrunde, eine einfach ausgebildete Vorrichtung zum Prüfen von Leiterplatten zu schaffen, mit der Leiterplatten mit einer hohen Leiterplattentestpunktdichte und/oder sehr kleinen Abständen zwischen den Leiterplattentestpunkten getestet werden können.

Die Aufgabe wird durch eine Vorrichtung mit den Merkmalen des Anspruchs 1 gelöst.

Erfindungsgemäß sind die Testanschlüsse der Auswerteelektronik jeweils mit mehreren Leiterplattentestpunkten und/oder mit mehreren Kontaktstellen eines Grundrasters der Prüfvorrichtung verbunden, wodurch sich die Anzahl der Einheiten der Auswerteelektronik im Vergleich zu der Auswerteelektronik einer vergleichbaren Prüfvorrichtung erheblich vermindert und sich der gesamte Aufbau der Prüfvorrichtung deutlich einfacher gestaltet.

Ferner liegt der Erfindung die Aufgabe zugrunde, ein Verfahren zum Prüfen von Leiterplatten mittels einer einen Adapter aufweisenden Prüfvorrichtung zu schaffen, das einfacher und schneller als vergleichbare bekannte Verfahren ist.

Die Aufgabe wird durch ein Verfahren mit den Merkmalen des Anspruchs 20 gelöst.

Das erfindungsgemäße Verfahren erlaubt eine deutliche Verminderung der Anzahl der einzelnen Meßvorgänge.

Vorteilhafte Ausgestaltungen der Erfindung sind in den Unteransprüchen angegeben.

Die Erfindung wird beispielhaft anhand der Zeichnungen näher erläutert. Es zeigen:
- Fig. 1: schematisch vereinfacht ein Grundraster in der Draufsicht,
- Fig. 2: eine Grundrasterplatte im Querschnitt im Bereich zweier Scankanäle,
- Fig. 3: ein Leiterbahnmuster in der Draufsicht zur Veranschaulichung der Adjacency-Kriterien,
- Fig. 4: einen Adapter mit einer Verknüpfungsmaske im Querschnitt,
- Fig. 5: einen zweistufigen Adapter im Querschnitt,
- Fig. 6: schematisch vereinfacht ein weiteres Grundraster in der Draufsicht,
- Fig. 7: schematisch die Leiterbahnen eines Translators in der Draufsicht, und
- Fig. 8: einen Schnitt durch einen Bereich einer weiteren Prüfvorrichtung.

Die Prüfvorrichtung weist eine Auswerteelektronik auf, welche elektrisch mit einem Grundraster verbunden ist. Auf dem Grundraster lagert ein Adapter. Auf den Adapter wird eine zu prüfende Leiterplatte aufgelegt, wobei der Adapter einen elektrischen Kontakt zwischen den auf der Leiterplatte befindlichen Leiterplattentestpunkten und jeweils einer Kontaktstelle bzw. einem Padfeld des Grundrasters herstellt. In den Adapter kann ein Translatorboard eingesetzt sein, mit welchem die elektrischen Verbindungen von einer Kontaktstelle zu einem davon entfernt angeordneten Leiterplattentestpunkt der Leiterplatte umgeleitet werden können.

Die erfindungsgemäße Vorrichtung weist ein Grundrasterfeld 1 mit mehreren Kontaktstellen 2 auf, die auf einer Grundrasterplatte 3 ausgebildet sind. Es sind zumindest zwei Kontaktstellen 2 des Grundrasterfeldes 1 in der Grundrasterplatte 3 elektrisch verbunden.

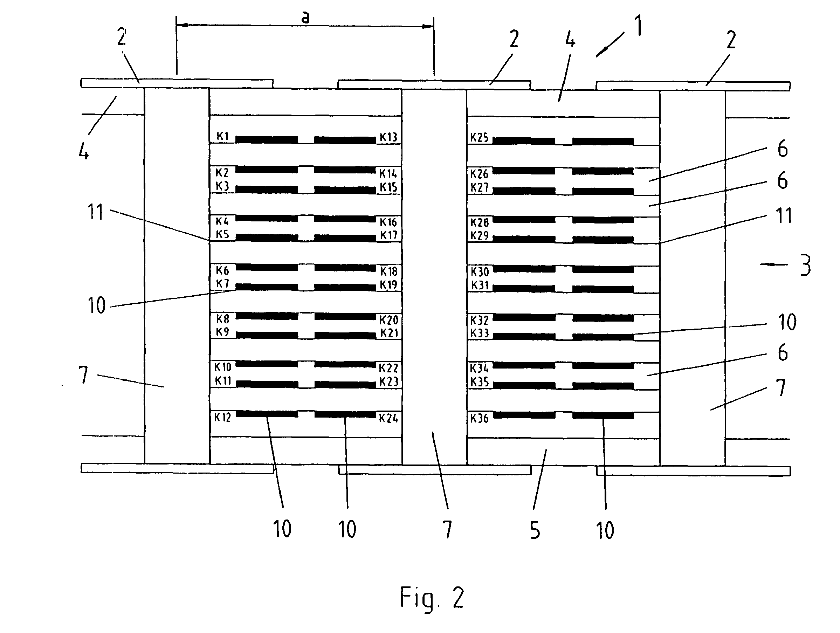

Die Grundrasterplatte 3 ist vorzugsweise aus einer laminierten Leiterplatte ausgebildet. Das in Fig. 2 abgebildete Ausführungsbeispiel weist eine obere und eine untere Begrenzungslage 4, 5 und dreizehn Zwischenlagen 6 auf.

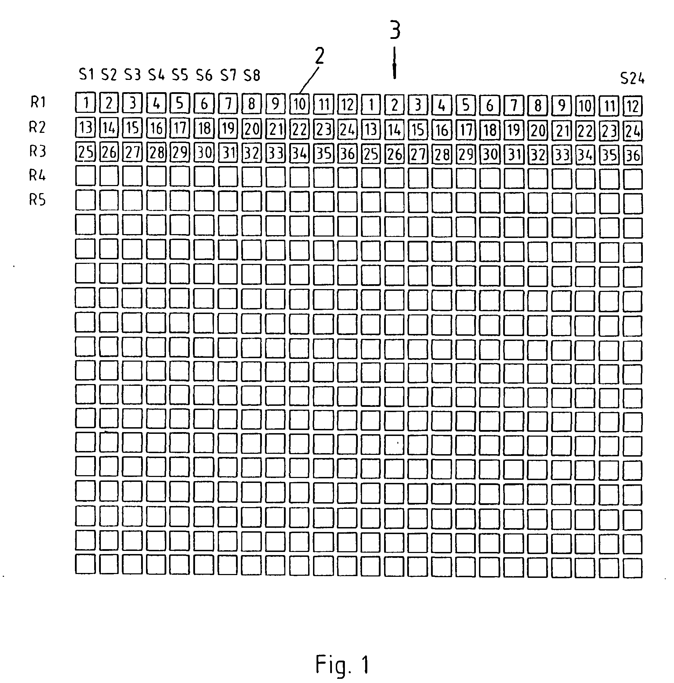

Von den Kontaktstellen 2 erstreckt sich senkrecht durch die oberste Lage 4 und alle Zwischenlagen 6 jeweils eine vertikale Durchkontaktierung 7. Die Durchkontaktierungen 7 sind in der Regel als Bohrungen mit einer leitenden, metallisierten Beschichtung ausgebildet. Die Durchkontaktierungen 7 sind bspw. in einem regelmäßigen quadratischen Raster angeordnet, wobei der Mittenabstand a zwischen zwei Durchkontaktierungen 7 bspw. 500 µm beträgt. Bei keramischen Grundrasterplatten 3 kann der Mittenabstand a bis auf 100 µm verringert werden. Es sind auch andere Arten einer regelmäßigen Rasterung möglich, wie z.B. ein rechteckiges oder hexagonales Raster oder auch ein Raster, bei welchem die Durchkontaktierungen 7 benachbarter Reihen zueinander versetzt angeordnet sind. Die Durchkontaktierungen 7 und die entsprechenden Kontaktstellen 2 sind somit in Reihen (R1, R2, ...) und Spalten (S1, S2, ...) angeordnet (Fig. 1). Zwischen zwei Reihen von Durchkontaktierungen 7 sind jeweils Leiterbahnen 10 in der Grundrasterplatte 3 eingebettet, die nachfolgend als Scankanäle bezeichnet werden. Bei dem in den Fig. 1 dargestellten Ausführungsbeispiel sind zwischen zwei Reihen von Durchkontaktierungen 7 jeweils zwölf und bei dem in Fig. 2 dargestellten Ausführungsbeispiel jeweils vierundzwanzig Scankanäle 10 vorgesehen, die jeweils paarweise in einer Zwischenschicht zwischen zwei Zwischenlagen 6 angeordnet sind. Die jeweils zwölf Paare benachbart zu einer Reihe von Durchkontaktierungen 7 angeordneten Scankanäle 10 sind dieser Reihe zugeordnet, d.h., daß jede Durchkontaktierung 7 und damit jede Kontaktstelle 2 einer bestimmten Reihe elektrisch mit einem der dieser Reihe zugeordneten Scankanäle 10 über eine Stichleitung 11 verbunden ist.

In Fig. 2 sind 36 Kanäle mit K1 bis K36 bezeichnet, wobei in Fig. 1 in die Kontaktstellen 2 der ersten drei Reihen die Nummern der Kanäle eingetragen sind, mit welchen sie elektrisch verbunden sind. Gemäß der Ausführungsform nach Fig. 1 sind in einer Reihe jede zwölfte Kontaktstelle 2 mit dem gleichen Scankanal 10 elektrisch verbunden ist. Mit anderen Worten heißt dies, daß jede zwölfte Kontaktstelle 2 einer Reihe über einen Scankanal 10 elektrisch verbunden ist. Es werden somit eine Anzahl von Kontaktstellen 2 jeweils mit einem Scankanal 10 erfaßt. Hierdurch vereinfacht sich die Leiterbahnenstruktur in der Grundrasterplatte 3 wesentlich, so daß die Durchkontaktierungen 7 mit einem viel geringeren Abstand als bei herkömmlichen Grundrasterplatten angeordnet werden können, wodurch die Rasterdichte der Kontaktstellen wesentlich erhöht werden kann.

Die Scankanäle 10 sind an den Rändern der Grundrasterplatte 3 an elektrische Verbinder wie. z.B. Steckverbinder angeschlossen, an welche die Scan- bzw. Auswerteelektronik angeschlossen werden kann. Trotz einer Vielzahl von Kontaktstellen 2 auf dem Grundrasterfeld 1 ist die Anzahl der Testanschlüsse der Auswerteelektronik relativ gering, da lediglich für einen jeden Scankanal ein Testanschluß vorgesehen werden muß. Bei bekannten Prüfvorrichtungen ist für jede Kontaktstelle ein eigener Testanschluß zur Auswerteelektronik vorgesehen. Gegenüber diesen bekannten Prüfvorrichtungen vermindert sich die Auswerteelektronik erheblich, nämlich in exakt dem Maße, mit welchem die Kontaktstellen an den Scankanälen zusammengefaßt und die Testanschlüsse verringert werden.

Anstatt eines Steckverbinders kann jede geeignete lösbare und nicht lösbare elektrische Verbindung an der Schnittstelle zwischen der Grundrasterplatte 3 und der Auswerteelektronik vorgesehen werden. Bspw. können die Testanschlüsse an die Scankanäle angelötet sein. Eine solche unlösbare elektrische Verbindung ist vor allem dann geeignet, wenn die Auswerteelektronik in die Grundrasterplatte 3 integriert bzw. unterhalb an die Grundrasterplatte 3 an diese anliegend befestigt wird.

Der mechanische Aufbau der erfindungsgemäßen Vorrichtung ist zudem sehr einfach, da die elektrischen Anschlüsse seitlich an der Grundrasterplatte 3 angeordnet sind, so daß die Elektronik räumlich getrennt von der Grundrasterplatte 3 angeordnet werden kann. Somit können unmittelbar unter der Grundrasterplatte Druckelemente, wie z.B. eine Druckplatte, angeordnet sein, mit welcher die Grundrasterplatte 3 und ein Adapter und/oder ein Translator gegen die zu prüfende Leiterplatte gedrückt werden.

Durch die elektrische Verbindung der Kontaktstellen werden einzelne Netze der zu prüfenden Leiterplatte elektrisch verbunden, so daß eine für sog. Paralleltester (= Prüvorrichtung mit Adapter) herkömmliche Unterbrechungs- bzw. Kurzschlußmessung nicht möglich ist.

Eine Möglichkeit, unerwünschte elektrische Verbindungen zwischen den einzelnen Netzen zu vermeiden, ist die Anwendung der von den Fingertestern bekannten Adjacency-Programme, die ermitteln, zwischen welchen Netzen der zu prüfenden Leiterplatte praktisch keine elektrischen Verbindungen in der Leiterplatte auftreten können, so daß eine elektrische Verbindung zweier solcher Netze, die das Adjacency-Kriterium erfüllen, über die Kontaktstellen des Grundrasters die Messung nicht negativ beeinträchtigt.

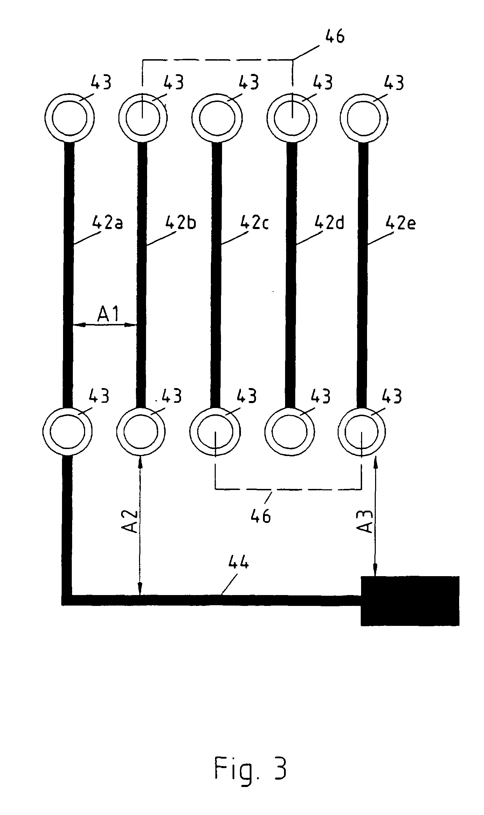

In Fig. 3 sind schematisch vereinfacht fünf Leiterbahnabschnitte 42a bis 42e dargestellt. Diese Leiterbahnabschnitte 42a bis 42e sind zueinander jeweils parallel angeordnet, wobei sie an ihren Endpunkten jeweils einen Kontaktring 43 aufweisen. Lediglich der in Fig. 3 linksseitig angeordnete Leiterbahnabschnitt 42a ist mit einem weiteren Leiterbahnabschnitt 44 verbunden, der abgewinkelt ist und parallel zu einer Reihe der Kontaktringe 43 der übrigen Leiterbahnabschnitte 42b bis 42e verläuft. Der Leiterbahnabschnitt 44 weist an einem Ende eine Kontaktfläche 45 auf.

Ob zwischen zwei bestimmten Leiterbahnen eine elektrische Verbindung auftreten kann, kann nach folgenden Adjacency-Kriterien beurteilt werden:
1. Befindet sich zwischen zwei bestimmten Leiterbahnen eine weitere Leiterbahn, so kann zwischen den beiden bestimmten Leiterbahnen nicht unmittelbar ein Kurzschluß auftreten. Zwischen den Leiterbahnabschnitten 42b und 42d verläuft der Leiterbahnabschnitt 42c und zwischen den Leiterbahnabschnitten 42c und 42e verläuft der Leiterbahnabschnitt 42d, so daß zwischen den Leiterbahnabschnitten 42b und 42d bzw. 42c und 42e nicht unmittelbar ein Kurzschluß auftreten kann, ohne daß zwischen den unmittelbar benachbarten Leiterbahnabschnitten ein Kurzschluß auftritt. Es genügt somit, daß die unmitelbar benachbarten Leiterbahnen auf Kurzschluß getestet werden. Die nicht unmittelbar benachbarten Leiterbahnen erfüllen somit ein Adjacency-Kriterium und können für einen Kurzschlußtest miteinander elektrisch verknüpft werden, wie es in Fig. 3 schematisch durch die gestrichelte Linie 46 angedeutet ist.
2. Ist der Abstand zwischen zwei Leiterbahnen an keiner Stelle geringer als ein vorbestimmter Adjacency-Abstand, so kann ein Kurzschluß zwischen den beiden Leiterbahnen grundsätzlich ausgeschlossen werden. Der aus den Leiterbahnabschnitten 42a und 44 bestehende Leiterbahnzug weist zu den einzelnen Leiterbahnen unterschiedliche Abstände A1 bis A3 auf, ohne daß eine weitere Leiterbahn dazwischen angeordnet ist. Diese Abstände A1 bis A3 sind mit dem Adjacency-Abstand zu vergleichen, wobei die jeweiligen Leiterbahnen das Adjacency-Kriterium erfüllen wenn die Abstände A1 bis A3 zu den einzelnen Leiterbahnen 42b bis 42e größer als der Adjacency-Abstand sind. Der Adjecency-Abstand ist im wesentlichen vom Fertigungsverfahren, mit welchem die Leiterplatte hergestellt wird, abhängig und liegt in der Regel im Bereich von 0,5 mm bis 5 mm und vorzugsweise im Bereich von 1 mm bis 3 mm.
3. Sind die Leiterbahnen in anderen Lagen in der Leiterplatte angeordnet, so können sie keinen Kurzschluß bilden und erfüllen ein weiteres Adjacency-Kriterium.

Bei der Beurteilung, ob zwischen zwei Leiterbahnen ein Kurzschluß auftreten kann, kann nach einem oder mehreren der obigen Adjacency-Kriterien vorgegangen werden, die logisch mit einem "oder" verknüpft sind, so daß die Erfüllung eines einzigen Kriteriums genügt, um einen Kurzschluß zwischen den Leiterbahnen auszuschließen. Werden spezielle Herstellungsverfahren zum Herstellen der Leiterplatten eingesetzt, z.B. wenn Stopplack zwischen bestimmten Bereichen auf der Leiterplatte aufgetragen wird, so daß kein Kurzschluß zwischen Leiterbahnen aus diesen Bereichen auftreten kann, können die oben angeführten Adjacency-Kriterien um diese speziellen Kriterien ergänzt werden.

Die das Adjacency-Kriterium erfüllenden Leiterbahnpaare bzw. Netzpaare können über die Scankanäle 10 elektrisch verbunden werden.

Diese "erwünschten" Kurzschlüsse bzw. elektrischen Verbindungen beeinträchtigen nicht nur die Messung, sondern bewirken sogar eine Beschleunigung und Vereinfachung des Meßvorganges, da mit jeweils einer Messung zwei oder mehrere Netze gleichzeitig getestet werden.

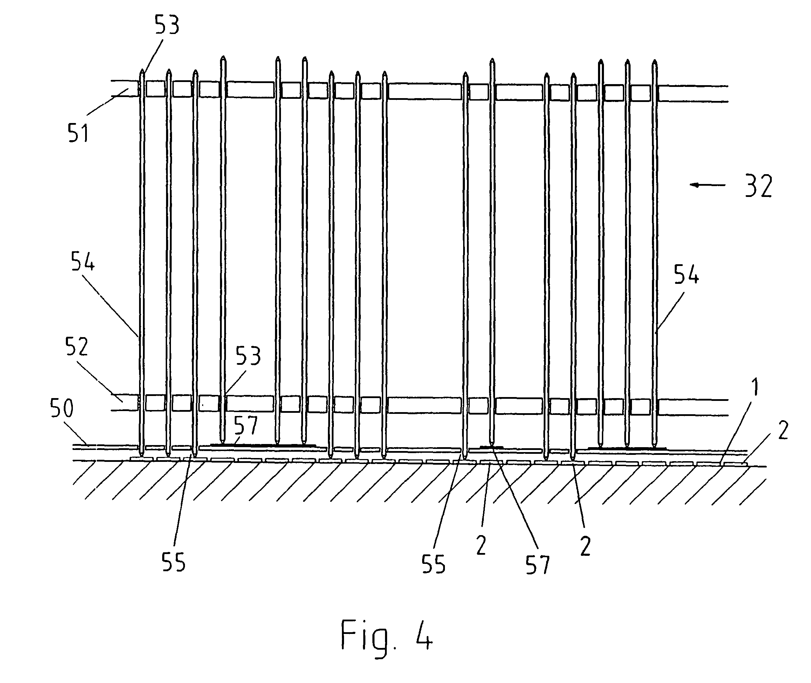

Derartige erwünschte elektrische Verbindungen können auch mittels einer zwischen der Grundrasterplatte und dem Adapter eingefügten Verknüpfungsmaske 50 künstlich erzeugt werden (Fig. 4). In Fig. 4 ist ein an sich bekannter Adapter 32 schematisch dargestellt mit einer oberen und unteren Begrenzungslage 51, 52, in welche jeweils in einem vorbestimmten Muster Bohrungen 53 eingebracht sind, durch welche sich Nadeln 54 erstrecken, die die Kontaktstellen 2 eines Grundrasterfeldes 1 mit den Leiterplattentestpunkten einer zu testenden Leiterplatte elektrisch verbinden.

Die Erfindung ist nicht auf den oben beschriebenen Adapter 32 beschränkt. Gleichermaßen kann ein Knicknadeladapter oder ein Adapter, der statt den Nadeln 54 Biegenadeln oder elektrisch leitende Gumminoppen aufweist, verwendet werden.

Die Verknüpfungsmaske 50 ist auf dem Grundrasterfeld 1 angeordnet und weist eine Vielzahl von Löchern 55 auf, die von den Nadeln 54 des Adapters 32 durchsetzt werden, um mit den Kontaktstellen 2 des Grundrasters 1 in Kontakt zu treten. Auf der zum Adapter 32 zeigenden Oberfläche der Verknüpfungsmaske 50 sind Leiterbahnen 57 aufgebracht, die jeweils zumindest zwei Nadeln 54 des Adapters 32, die nicht mit den Kontaktstellen 2 des Grundrasters 1 in Kontakt stehen, elektrisch verbinden. Über diese Leiterbahnen 57 und die entsprechenden Nadeln 54 des Adapters 32 werden gezielt elektrische Verbindungen zwischen den einzelnen Netzen der zu testenden Leiterplatte hergestellt, wodurch die verknüpften Netze auf einmal wie ein einzelnes Netz auf Kurzschlüsse gemessen werden können, wodurch sich das Messverfahren beschleunigt. In Fig. 4 sind die Leiterbahnen 57 an der Oberfläche der Verknüpfungsmaske 50 dargestellt. Die Leiterbahnen 57 können im Rahmen der Erfindung auch innerhalb der Verknüpfungsmaske 50 ausgebildet sein, wobei sie an die Oberfläche nur zu kleinen Leiterbahnkontaktstellen geführt sind und eventuell an der Unterfläche unmittelbar mit einer Kontaktstelle 2 elektrisch verbunden sind. Eine solche Maske 50 kann in Kombination mit der Verknüpfungsfunktion oder auch ohne Verknüpfungsfunktion ein sehr dichtes Raster von Leiterbahnkontaktstellen vorsehen, wobei mehrere auf der Oberfläche der Maske 50 verteilt angeordnete Leiterbahnkontaktstellen mittels einer Leiterbahn 57 mit einer einzigen Kontaktstelle 2 des Grundrasters unmittelbar oder via einer Nadel 54, einem Netz und einer weiteren Nadel 54 verbunden sind. Die Leiterbahnkontaktstellen sind vorzugsweise deutlich kleiner als die Kontaktstellen 2 und sind bspw. als Quadrate mit einer Kantanlänge von 100 µm bis 800 µm ausgebildet. Mit einer solchen Adaptermaske ist es somit möglich, die Dichte der Kontaktstellen 2 des Grundrasters alleine durch Auflegen der Maske mit den enger und dichter angeordneten Leiterbahnkontaktstellen zu erhöhen.

Im Idealfall können mittels der elektrischen Verbindungen der Verknüpfungsmaske 50 zwischen den einzelnen Netzen der zu testenden Leiterplatte die Netze zu insgesamt nur zwei Gruppen von Netzen verknüpft bzw. elektrisch verbunden sein, so daß mit lediglich einer einzigen Messung zwischen den beiden Gruppen ermittelt werden kann, ob auf der Leiterplatte ein Kurzschluß vorliegt.

Diese Verknüpfungsplatte 50 kann auch zum Messen von Unterbrechungen eingesetzt werden, wobei einzelne Netze einer zu testenden Leiterplatte an ihren Enden in Reihe über die Verknüpfungsplatte 50 elektrisch verbunden werden, so daß sich ein langer Leiterzug ergibt, der in einem einzigen Meßvorgang auf Unterbrechungen getestet werden kann.

Diese Verknüpfungsplatte kann auch in sehr vorteilhafter Weise zusammen mit der oben beschriebenen Prüfvorrichtung verwendet werden, bei der mehrere Kontaktstellen über einen Scankanal 10 miteinander verbunden sind, wobei durch die Verknüpfungsplatte 50 mehrere miteinander verknüpfte Netze der Leiterplatte lediglich mit einer einzigen Kontaktstelle 2 verbunden werden.

In Fig. 4 ist die Verknüpfungsmaske 50 relativ dick und mit Abstand zum Grundrasterfeld 1 angeordnet, so daß die auf den Leiterbahnen 57 aufliegenden Nadeln 54 an der oberen Lage 51 des Adapters deutlich weiter überstehen als die übrigen Nadeln 54, die in den Löchern 55 stecken. Dies ist durch die zeichnerische Darstellung bedingt. Derartige Verknüpfungsmasken 50 weisen eine Dicke von 50 µm auf, so daß die durch die Verknüpfungsmaske 50 hervorgerufenen Höhenunterschiede der Nadeln im Bereich der üblichen Toleranzen liegen. Es kann jedoch auch eine dickere und stärkere Verknüpfungsmaske verwendet werden, wobei dann zum Ausgleich die Länge der auf den Leiterbahnen 57 aufliegenden Nadeln 54b etwas kürzer zu bemessen ist.

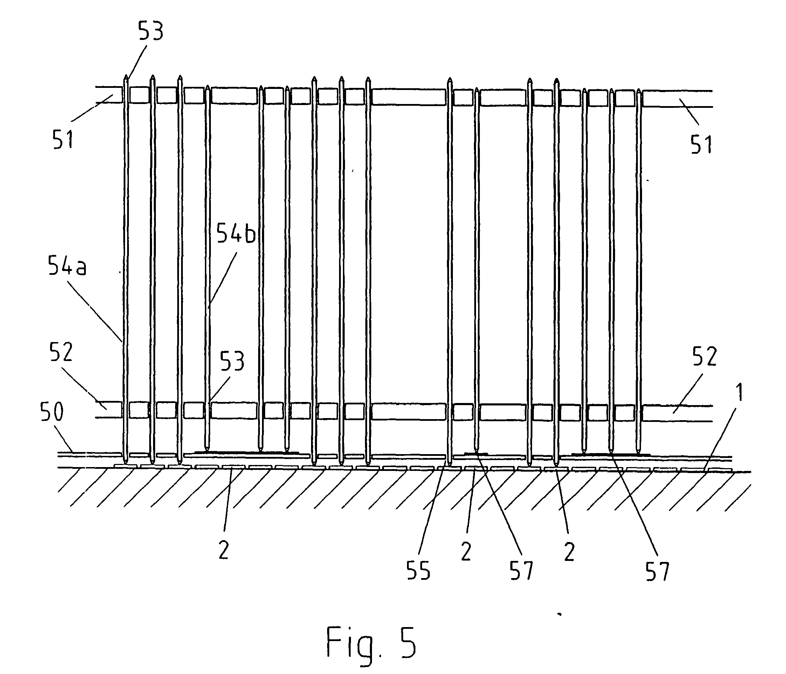

In Fig. 5 ist ein ähnlicher Adapter 32 mit Verknüpfungsplatte 50 dargestellt. Im grundsätzlichen Aufbau ist dieser Adapter identisch mit dem in Fig. 4 gezeigten; er unterscheidet sich lediglich in der Länge der Nadeln, wobei die Nadeln 54a, die in den Löchern 55 der Verknüpfungsplatte 50 stecken, länger als die Nadeln 54b sind, die auf den Leiterbahnen 57 der Verknüpfungsplatte 50 aufliegen.

Mit diesem Adapter 32 können die Netze einer zu testenden Leiterplatte in einem ersten Meßvorgang auf Kurzschluß getestet werden, wobei lediglich die längeren Nadeln 54a mit Leiterplattentestpunkten in Kontakt stehen, und in einem zweiten Meßvorgang die kürzeren Nadeln 54b mit den Leiterplattentestpunkten in Kontakt gebracht werden, indem die zu testende Leiterplatte stärker gegen den Adapter gedrückt wird.

Während des ersten Meßvorganges, während dem nur die längeren Nadeln 54a mit den Leiterplattentestpunkten in Kontakt stehen, wird eine Kurzschlußmessung durchgeführt. Hierbei ist jedes Netz mit einer einzigen Nadel 54b kontaktiert.

Während des zweiten Meßvorganges, während dem sowohl die kürzeren als auch die längeren Nadeln 54b, 54a mit den Leiterplattentestpunkten in Kontakt stehen, wobei durch die Kontaktierung mit den kürzeren Nadeln 54b einzelne Teilnetze in Reihe geschaltet sind, wird der Unterbrechungstest durchgeführt.

Im Idealfall wird ohne die Anwendung der Adjacency-Kriterien für jedes Netz der zu testenden Leiterplatte lediglich ein Scankanal 10 benötigt, da während des Kurzschlußtests jedes Netz einmal kontaktiert werden muß und während des Unterbrechungstestes die einzelnen Netze bzw. Teilnetze lediglich miteinander verknüpft werden. Mit der Anwendung der Adjacency-Kriterien ist grundsätzlich eine noch weitere Verminderung der Anzahl der notwendigen Scankanäle möglich.

Unterbrechungen und/oder Kurzschlüsse können auch mittels einer Kapazitätsmessung ermittelt werden, wie sie von Fingertestern bekannt ist. Hierbei können mehrere Netze gleichzeitig mit einer einzigen Messung erfaßt werden.

Die Kapazitätsmessung kann auch unter Berücksichtigung des Adjacency-Kriteriums erfolgen, wodurch die Meßsicherheit erhöht wird.

Die oben beschriebenen Möglichkeiten zur Vermeidung unerwünschter elektrischer Verbindungen können einzeln und in Kombination angewandt werden.

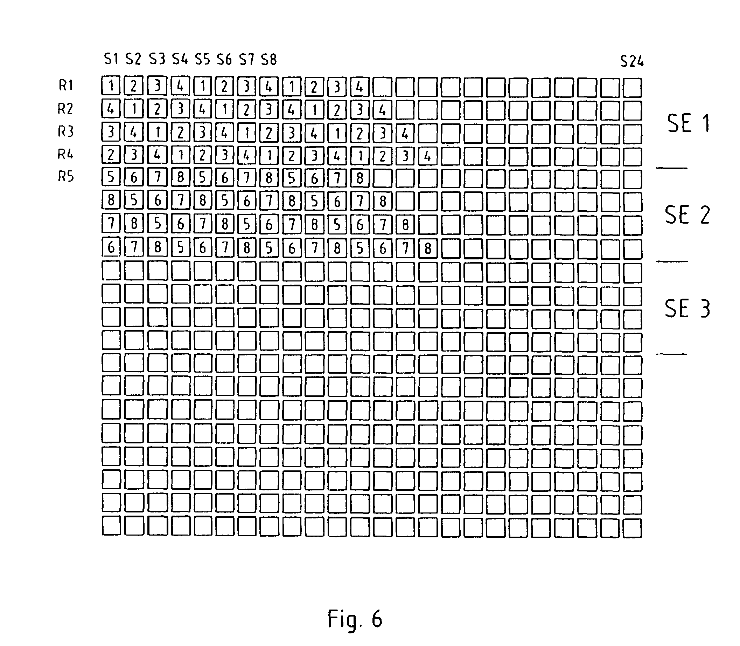

In Fig. 6 ist ein weiteres Ausführungsbeispiel eines erfindungsgemäßen Grundrasterfeldes dargestellt. Dieses Grundrasterfeld ist in 20 horizontale Reihen (R1 - R20) und 24 vertikale Spalten (S1 - S24) aufgeteilt. Die Anzahl der Reihen und Spalten wird in einer tatsächlichen Anwendung bei weitem größer sein. Vier benachbarte Reihen (R1 - R4; R5 - R8; R9 - R12; usw.) bilden jeweils ein Segment (SE1, SE2, SE3, usw.). In den Segmenten ist jeweils jede vierte Kontaktstelle einer Reihe mit einem Scankanal verbunden. In den Segmenten sind Kontaktstellen 2 der einzelnen Reihen mit demselben Scankanal verbunden, wobei die mit einem Scankanal verbundenen Kontaktstellen zweier benachbarter Reihen vorzugsweise diagonal an der Grundrasterplatte angeordnet sind. Bei dem in Fig. 6 dargestellten Ausführungsbeispiel sind pro Segment vier Scankanäle vorgesehen. Im ersten Segment sind mit dem ersten der Scankanäle die Kontaktstellen 1, mit dem zweiten Scankanal die Kontaktstellen 2, mit dem dritten Scankanal die Kontaktstellen 3 und mit dem vierten Scankanal die Kontaktstellen 4 verbunden. Die Scankanäle weisen elektrische Verbindungen zu Kontaktstellen 2 aus mehreren Reihen auf, wobei die mit einem Scankanal verbundenen Kontaktstellen 2 von benachbarten Reihen oder Spalten vorzugsweise zueinander versetzt angeordnet sind. Da die Scankanäle mit Kontaktstellen aus mehreren Reihen verbunden sind, wird die Anzahl der Scankanäle weiter reduziert.

Die Scankanäle 10 zwischen den einzelnen Lagen 6 in der Grundrasterplatte 3 können in der Draufsicht auf die Grundrasterplatte 3 in unterschiedlichen Richtungen angeordnet und insbesondere senkrecht zueinander angeordnet sein, wodurch eine örtliche Selektivität erzielt wird.

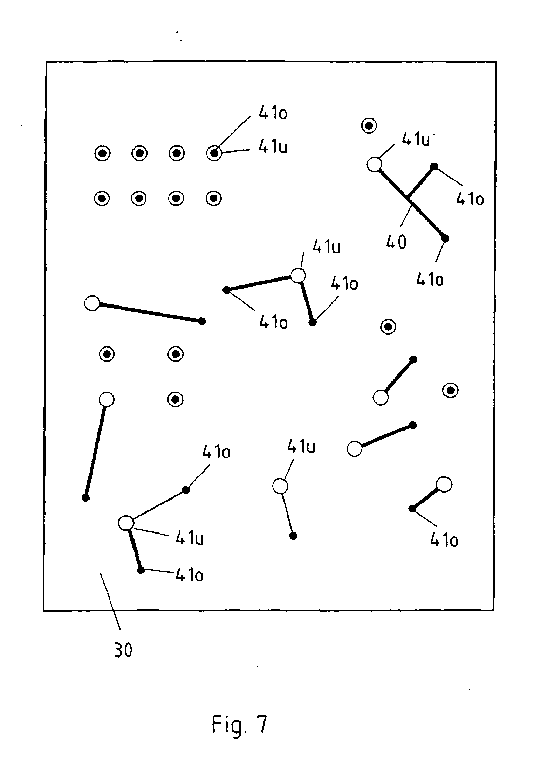

Das erfindungsgemäße Prinzip der Erzielung einer hohen Leiterplattentestpunktdichte durch elektrisches Verbinden bzw. Kurzschließen einzelner elektrischer Verbindungen zwischen den Leiterplattentestpunkten der zu testenden Leiterplatte und den Testanschlüssen der Auswerteelektronik kann auch durch elektrisches Verbinden in einem Translatorboard 30 (Fig. 7) erfolgen. Das Translatorboard 30 ist hierzu zwischen zwei Adaptern angeordnet, einer Vollrasterkassette bzw. einem Vollrasteradapter, der zwischen dem Grundraster und dem Translatorboard 30 angeordnet ist, und dem Pintranslatoradapter 32, der zwischen dem Translatorboard 30 und der zu testenden Leiterplatte angeordnet ist. Im Translatorboard 30 sind mehrere Pins des Pintranslatoradapters miteinander elektrisch mittels einer Leiterbahn 40 verbunden, wobei die Leiterbahnen 40 jeweils nur mit einer einzigen Nadel des Vollrasteradapters bzw. einer einzigen Kontaktstelle 2 des Grundrasterfeldes in Kontakt stehen. Diese Leiterbahnen verknüpfen somit zwei oder mehrere obere Kontaktflächen 41o mit einer einzigen unteren Kontaktfläche 41u. Das "elektrische Verbinden über das Translatorboard" ermöglicht, daß die Anzahl der Pins des Pintranslatoradapters größer als die Anzahl der Nadeln des Vollrasteradapters bzw. größer als die Anzahl der Kontaktstellen des Grundrasterfeldes sind. Diese Ausführungsform ist sehr kostengünstig in bestehenden Prüfvorrichtungen realisierbar und bewirkt eine Erhöhung der effektiven Leiterplattentestpunktdichte. Die oben beschriebenen Methoden zur Vermeidung unerwünschter elektrischer Verbindungen können gleichermaßen angewandt werden.

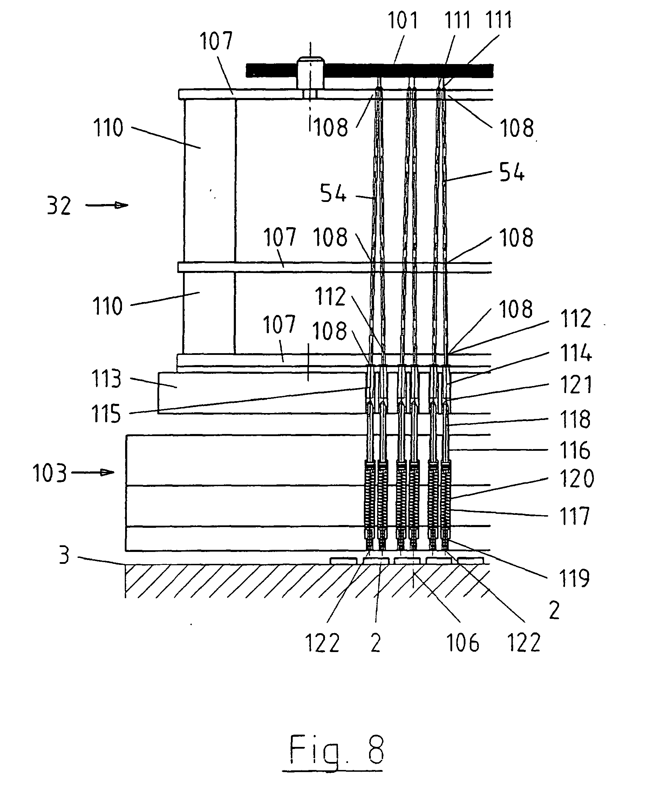

Eine weitere erfindungsgemäße Vorrichtung zum Prüfen von Leiterplatten 101 wird nachfolgend anhand von Fig. 8 beschrieben. Diese Prüfvorrichtung weist einen Adapter 32 auf, der zwischen einer zu prüfenden Leiterplatte 101 und einer Vollrasterkassette 103 angeordnet ist. Die Vollrasterkassette 103 liegt auf einer Grundrasterplatte 3 der Prüfvorrichtung auf, die in herkömmlicher Weise mit einer Vielzahl von regelmäßig angeordneten Kontaktstellen bzw. Padflächen 2 ausgebildet sein kann. Die Padflächen 2 bestehen vorzugsweise aus rechteckigen Goldplättchen, wobei jede Padfläche 2 über eine Leiterbahn 106 mit einem Testanschluß einer an sich bekannten Auswerteelektronik (nicht dargestellt) verbunden ist. Die Leiterbahnen 106 können alternativ auch als Scankanäle ausgebildet sein.

Der Adapter 32 weist z.B. drei horizontal angeordnete Führungsplatten 107 auf, in welche Durchgangsbohrungen 108 eingebracht sind. Die Durchgangsbohrungen 108 werden von etwa vertikal ausgerichteten Prüfnadeln 54 durchgriffen. Die Prüfnadeln 54 dienen als Prüfkontakte. Die Prüfkontakte können auch als Federkontakte oder Leitgummis oder dgl. ausgebildet sein. Als Prüfkontakte dienende Leitgummis sind bspw. aus der EP 0 369 112 B1 bekannt.

Am Adapter 32 sind seitlich vertikale Seitenwandungen 110 vorgesehen, die die Führungsplatten 107 in einem vorbestimmten Abstand halten und den durch die Führungsplatten 107 begrenzten Raum seitlich abschließen.

Die Prüfnadeln 54 sind einfache Starrnadeln, die mit einem oberen Ende 111 über die oberste Führungsplatte 107 hervorragen, um jeweils einen Leiterplattentestpunkt an der Leiterplatte 101 zu kontaktieren.

Die unteren Enden 112 der Prüfnadeln 54 lagern jeweils in den Bohrungen 108 der untersten Führungsplatte 107. Der Adapter 32 weist unterhalb der untersten Führungsplatte 107 eine Basisplatte 113 auf, in der vertikale Durchgangsbohrungen 114 eingebracht sind. Die Durchgangsbohrungen 114 sind zu den Bohrungen 108 der untersten Führungsplatte 107 fluchtend angeordnet, wobei in den Durchgangsbohrungen 114 jeweils eine zylinderförmige Buchse 115 verschiebbar lagert und in der Bohrung 114 gegen ein Herausfallen gesichert ist.

Die Vollrasterkassette 103 hat einen an sich bekannten Aufbau aus mehreren Lagen mit vertikalen Bohrungen 116, in welchen jeweils ein Vollrasterstift 117 lagert. Die Vollrasterstifte 117 bestehen jeweils aus einem oberen und einem unteren Stiftabschnitt 118, 119, die jeweils über eine Schraubenfeder 120 miteinander elastisch und elektrisch leitend verbunden sind. Die Feder 120 weist einen größeren Durchmesser als die Stiftabschnitte 118, 119 auf, und die jeweiligen Bohrungen 116 sind stufig ausgeführt, so daß die Vollrasterstifte 117 verliersicher in der Vollrasterkassette gehalten werden. Das freie Ende des oberen Stiftabschnitts 118 ist als Spitze 121 ausgebildet und das freie Ende des unteren Stiftabschnittes 119 weist eine stumpfe Kontaktfläche 122 auf.

Mit den stumpfen Kontaktflächen 122 liegen die Vollrasterstifte 117 auf den Kontaktstellen 2, wobei sie nach oben gegen die Buchsen 115 gedrückt werden und so die Prüfnadeln 54 elastisch mit einem Druck nach oben gegen die Prüfpunkte der Leiterplatte 101 beaufschlagen. Die Kontaktstellen 2 sind in einem regelmäßigen Raster angeordnet und bilden somit das Grundrasterfeld. Gegenüber diesem regelmäßigen Raster des Grundrasterfeldes sind die Prüfnadeln 54 ausgelenkt, so daß sie das gleichmäßige Raster des Grundrasterfeldes auf die ungleichmäßige Konfiguration der Leiterplattentestpunkte umsetzen.

Ein wesentlicher Unterschied zu herkömmlichen Prüfvorrichtungen liegt darin, daß den Kontaktstellen 2 zwei oder mehrere Vollrasterstifte 117 bzw. Prüfnadeln 54 zugeordnet sind. Diese Zuordnung kann und wird in der Regel variieren, d.h., daß einige Kontaktstellen 2 mit nur jeweils mit keiner oder nur einer Prüfnadel 54 und einige Kontaktstellen 2 mit zwei oder mehreren Prüfnadeln 54 belegt sind. Die spezielle Belegung der Kontaktstellen 2 mit Prüfnadeln 54 hängt von dem zu prüfenden Typ von elektrischen Leiterplatten ab.

Durch die Mehrfachbelegung der Kontaktstellen 2 mit Prüfnadeln 54 wird die Anzahl der nutzbaren Meßpunkte erhöht.

Die oben beschriebenen Methoden zur Vermeidung unerwünschter elektrischer Verbindungen können gleichermaßen angewandt werden.

## Patentansprüche

1. Prüfvorrichtung zum Prüfen von Leiterplatten auf Unterbrechungen und Kurzschlüsse, die eine Anzahl von Leiterplattentestpunkten aufweisen, mit einer Auswerteelektronik, die eine Anzahl von Testanschlüssen aufweist, wobei jeder Leiterplattentestpunkt einer Leiterplatte mit einem Testanschluss der Auswerteelektronik über eine elektrische Verbindung in Kontakt steht, und zumindest zwei der elektrischen Verbindungen elektrisch miteinander verbunden sind, so dass zumindest zwei Leiterplattentestpunkte der zu testenden Leiterplatte mit einem einzigen Testanschluss in Verbindung stehen,
**dadurch gekennzeichnet,**
**dass** die Testanschlüsse der Auswerteelektronik elektrisch mit einem Grundraster (1) verbunden sind, wobei auf dem Grundraster (1) ein Adapter (32) und/oder ein Translator (30) angeordnet und eine zu prüfende Leiterplatte darauf aufgelegt werden können, wobei der Adapter (32) und/oder Translator (30) einen elektrischen Kontakt von auf der Leiterplatte befindlichen Leiterplattentestpunkten zu Kontaktstellen (2) des Grundrasters (1) herstellt,
**dass** das Grundraster (1) auf der Oberfläche einer Grundrasterplatte (3) ausgebildet ist, wobei zumindest zwei Kontaktstellen (2) des Grundrasters (1) miteinander in der Grundrasterplatte (3) elektrisch verbunden sind,
**dass** die Grundrasterplatte (3) als laminierte Leiterplatte mit einer oberen und unteren Begrenzungslage (4, 5) und Zwischenlagen (6) ausgebildet ist,
**dass** sich von den Kontaktstellen (2) senkrecht nach unten durch die einzelnen Lagen (4, 6) der Grundrasterplatte (3) Durchkontaktierungen (7) erstrecken, wobei die Durchkontaktierungen (7) und die Kontaktstellen (2) in einem regelmäßigen Raster angeordnet sind, und
**dass** die Durchkontaktierungen (7) und die Kontaktstellen (2) in mehreren Reihen angeordnet sind und zwischen den Reihen von Durchkontaktierungen jeweils zwischen zwei Zwischenlagen (6) ein Paar von Scankanälen (10) verläuft, wobei jeder Scankanal (10) der benachbarten Reihe von Durchkontaktierungen (7) zugeordnet ist und wobei die Durchkontaktierungen (7) jeweils mit einem einzelnen der Scankanäle (10) über jeweils eine Stichleitung (11) elektrisch verbunden sind.

2. Prüfvorrichtung zum Prüfen von Leiterplatten nach Anspruch 1,
**dadurch gekennzeichnet,**
**dass** lediglich Leiterplattentestpunkte von Netzen der zu prüfenden Leiterplatte elektrisch verbunden sind, die ein Adjacency-Kriterium erfüllen.

3. Prüfvorrichtung nach Anspruch 2,
**dadurch gekennzeichnet,**
**dass** zwei bestimmte Netze (42a - 42e, 44) der zu prüfenden Leiterplatte ein Adjacency-Kriterium erfüllen, wenn zwischen den beiden Netzen ein weiteres Netz (42b -42d) angeordnet ist.

4. Prüfvorrichtung nach Anspruch 2 oder 3,
**dadurch gekennzeichnet,**
**dass** zwei bestimmte Netze (42a - 42e, 44) der zu prüfenden Leiterplatte ein Adjacency-Kriterium erfüllen, wenn zwischen den beiden Netzen an keiner Stelle der Abstand geringer als ein vorbestimmter Adjacency-Abstand ist.

5. Prüfvorrichtung nach einem der Ansprüche 2 bis 4,
**dadurch gekennzeichnet,**
**dass** zwei bestimmte Netze (42a - 42e, 44) der zu prüfenden Leiterplatte ein Adjacency-Kriterium erfüllen, wenn die beiden Netze in unterschiedlichen Lagen der zu prüfenden Leiterplatte angeordnet sind.

6. Prüfvorrichtung nach einem der Ansprüche 1 bis 5,
**dadurch gekennzeichnet,**
**dass** die Kontaktstellen (2) einen Mittenabstand (a) von 100 µm bis 1 mm und vorzugsweise 300 µm bis 800 µm aufweisen.

7. Prüfvorrichtung nach einem der Ansprüche 1 bis 6,
**dadurch gekennzeichnet,**
**dass** jede x-te Kontaktstelle (2) einer Reihe von Kontaktstellen (2) mit dem gleichen Scankanal (10) elektrisch verbunden ist, wobei x eine ganze Zahl zwischen 3 und 100 und vorzugsweise zwischen 10 und 30 ist.

8. Prüfvorrichtung nach einem der Ansprüche 1 bis 6,
**dadurch gekennzeichnet,**
**dass** eine elektrische Schnittstelle seitlich an der Grundrasterplatte (3) zum Kontaktieren der Auswerteelektronik angeordnet ist.

9. Prüfvorrichtung nach Anspruch 8,
**dadurch gekennzeichnet,**
**dass** die elektrische Schnittstelle als Steckverbinder ausgebildet ist.

10. Prüfvorrichtung nach einem der Ansprüche 1 bis 9,
**dadurch gekennzeichnet,**
**dass** der Adapter (32) Nadeln aufweist, die auf jeweils einer Kontaktstelle (2) enden, wobei zumindest eine Nadel schräg gegenüber einer auf dem Grundraster senkrecht stehenden Linie angeordnet ist.

11. Prüfvorrichtung nach einem der Ansprüche 1 bis 10,
**dadurch gekennzeichnet,**
**dass** das Translatorboard (30) Leiterbahnen (40) aufweist, die die Leiterplattentestpunkte mit den Kontaktstellen (2) elektrisch verbinden, wobei die Leiterbahnen (40) so ausgebildet sind, dass kein Netz der zu testenden Leiterplatte mit einem Scankanal (10) mehrfach verbunden ist.

12. Prüfvorrichtung nach einem der Ansprüche 1 bis 11,
**dadurch gekennzeichnet,**
**dass** das Translatorboard (30) Leiterbahnen (40) aufweist, die die Leiterplattentestpunkte mit den Kontaktstellen (2) elektrisch verbinden, wobei die Leiterbahnen (40) so ausgebildet sind, dass kein Scankanal (10) mehrfach mit einem Leiterplattentestpunkt verbunden ist.

13. Prüfvorrichtung nach einem der Ansprüche 1 bis 12,
**dadurch gekennzeichnet,**
**dass** zum elektrischen Verbinden der elektrischen Verbindungen zwischen den Testanschlüssen und den Leiterplattentestpunkten eine Verknüpfungsmaske (50) vorgesehen ist, welche zwischen einem Adapter (32) und einem Grundraster (1) angeordnet ist, wobei die Verknüpfungsmaske (50) Leiterbahnen (57) aufweist, welche zumindest zwei Verbindungselemente, wie z.B. Nadeln (54; 54b), des Adapters (32) elektrisch verbinden und/oder zumindest zwei Verbindungselemente mit einer Kontaktstelle (2) des Grundrasters verbinden.

14. Prüfvorrichtung nach Anspruch 13,
**dadurch gekennzeichnet,**
**dass** die Verknüpfungsmaske (50) Löcher (55) aufweist, durch welche sich ein Teil der Nadeln (54) des Adapters (32) erstreckt, um mit den Kontaktstellen (2) des Grundrasters (1) in Kontakt zu treten.

15. Prüfvorrichtung nach Anspruch 13 oder 14,
**dadurch gekennzeichnet,**
**dass** die auf der Verknüpfungsmaske (50) aufliegenden Nadeln (54b) kürzer als die sich durch die Löcher (55) erstreckenden Nadeln (54a) sind, und während eines ersten Messvorganges lediglich die längeren Nadeln (54a) mit Leiterplattentestpunkten in Kontakt stehen, und während eines zweiten Messvorganges alle Nadeln (54a, 54b) mit Leiterplattentestpunkten in Kontakt stehen, da die zu testende Leiterplatte bspw. stärker angedrückt wird.

16. Prüfvorrichtung nach einem der Ansprüche 1 bis 15,
**dadurch gekennzeichnet,**
**dass** ein Translatorboard (30) vorgesehen ist, das an einer Oberfläche Kontaktflächen (41o) aufweist, die jeweils einem Leiterplattentestpunkt zugeordnet sind, und auf der gegenüberliegenden Oberfläche Kontaktflächen (41u) aufweist, die jeweils einem Testanschluss zugeordnet sind, wobei zwei der den Leiterplattentestpunkten zugeordneten Kontaktflächen (41o) gemeinsam mit einer einem Testanschluss zugeordneten Kontaktfläche (41 u) elektrisch verbunden sind.

17. Verfahren zum Prüfen von Leiterplatten auf Unterbrechungen und Kurzschlüsse mittels einer einen Adapter aufweisenden Prüfvorrichtung,
**dadurch gekennzeichnet,**
**dass** mit Hilfe von zumindest einem Adjacency-Kriterium ermittelt wird, ob zwei Netze der zu prüfenden Leiterplatte praktisch keinen Kurzschluss bilden können, so dass zwischen diesen beiden Netzen keine Kurzschlussprüfung erfolgen muss, und dass eine Prüfvorrichtung nach einem der Ansprüche 1 bis 16 verwendet wird.

18. Verfahren zum Prüfen nach Anspruch 17,
**dadurch gekennzeichnet,**
**dass** zumindest die zwei Netze, die ein Adjacency-Kriterium erfüllen, elektrisch verbunden werden und gemeinsam auf Kurzschluss gegenüber zumindest einem weiteren Netz bzw. einer weiteren Gruppe von miteinander verknüpften Netzen geprüft werden.

19. Verfahren nach Anspruch 17 oder 18,
**dadurch gekennzeichnet,**
**dass** zumindest zwei Netze in einer Reihenschaltung miteinander elektrisch verbunden werden und gemeinsam auf eine Unterbrechung und/oder einen Kurzschluss getestet werden, wobei lediglich an den Enden der Reihenschaltung in diese ein Strom eingespeist wird, um zu ermitteln ob eines der in Reihenschaltung geschalteten Netze eine Unterbrechung aufweist.

20. Verfahren nach einem der Ansprüche 17 bis 19,
**dadurch gekennzeichnet,**
**dass** zum elektrischen Verbinden zweier Netze eine Verknüpfungsmaske (50) verwendet wird, welche zwischen einem Adapter (32) und einem Grundraster (1) angeordnet wird, wobei die Verknüpfungsmaske (50) Leiterbahnen (57) aufweist, welche zumindest zwei Verbindungselemente, wie z.B. Nadeln (54; 54b), des Adapters (32) elektrisch verbinden.

## Claims

1. Test apparatus for testing printed circuit boards for interruptions and short-circuits, comprising a plurality of circuit board test points, including an electronic analyzer comprising a plurality of test connections, each circuit board test point being in contact with a test connection of the electronic analyzer via an electrical connection, and
at least two of said electrical connections are electrically connected to each other so that at least two circuit board test points of said board under test are in connection with a single test connection of said electronic analyzer,
**characterized in that**
**that** the test connection of the electronic analyzer is electrically connected to a grid pattern (1) wherein an adapter (32) and/or a translator (30) can be arranged on the grid pattern (1) and a board under test can be applied to it,
wherein the adapter (32) and/or the translator (30) make an electrical contact of test points (2) arranged on the circuit board with contact points on the grid base (1),
that the grid pattern (1) is formed on the surface of a grid base (3),
wherein at least two contact points (2) of the grid pattern (1) are connected to each other electrically in the grid base (3),
that the grid base (3) is arranged as a laminated circuit board with an upper and a lower restrictive layer (4, 5) and inner layers (6),
wherein feed-through contacts (7) extend from said contact points (2) vertically downwards through the individual layers (4,6) of said grid base (3), said feed-through contacts (7) and contact points (2) being arranged in a regular grid pattern, and wherein said feed-through contacts (7) and said contact points (2) are arranged in several rows and a pairs of scanning channels (10) are oriented between said rows respectively between two of inner layers (6) each scanning channel (10) being attached to the adjacent row of feed-through contacts (7), each of said feed-through contacts being electrically connected to a single scanning channel (10) via a branch line (11).

2. Test apparatus for testing circuit boards as set forth in claim 1,
**characterized in that**
only circuit board test points of circuits of said board under test are electrically connected when they satisfy an adjacency criterion.

3. Test apparatus as set forth in claim 2,
**characterized in that**
two specific circuits (42a - 42e, 44) of said board under test satisfy an adjacency criterion when a further circuit (42b - 42d) is arranged between said two circuits.

4. Test apparatus as set forth in one of the claims 2 or 3,
**characterized in that**
two specific circuits (42a - 42e, 44) of said board under test satisfy an adjacency criterion when at no point between said two circuits the spacing is less than a predetermined adjacency spacing.

5. Test apparatus as set forth in claims 2 to 4,
**characterized in that**
two specific circuits (42a - 42e, 44) of said board under test satisfy an adjacency criterion when both circuits are arranged in different layers of said circuit board to be tested.

6. Test apparatus as set forth in one of the claims 1 to 5,
**characterized in that**
said contact points (2) have a center-spacing (a) of 100 µm to 1 mm and preferably 300 µm to 800 µm.

7. Test apparatus as set forth in one of the claims 1 to 6,
**characterized in that**
each x^{th} contact point (2) of a row of contact points (2) is electrically connected to the same scanning channel (10), where x is a whole number between 3 and 100 and preferably between 10 and 30.

8. Test apparatus as set forth in one of the claims 1 to 6,
**characterized in that**
an electrical interface is arranged on the side of said grid base (3) for contacting said electronic analyzer.

9. Test apparatus as set forth in claim 8,
**characterized in that**
said electrical interface is configured as a connector.

10. Test apparatus as set forth in one of the claims 1 to 9,
**characterized in that**
said adapter (32) comprises probes, each of which ends in a contact point (2), at least one probe being arranged tilted relative to a line standing perpendicular to said grid pattern.

11. Test apparatus as set forth in one of the claims 1 to 10,
**characterized in that**
said translator board (30) comprises conductor paths (40) electrically connecting said circuit board test points to said contact points (2), said conductor paths (40) being configured so that no circuit of said board under test is multiply connected to a scanning channel (10).

12. Test apparatus as set forth in one of the claims 1 to 11,
**characterized in that**
said translator board (30) comprises conductor paths (40) electrically connecting said circuit board test points to said contact points (2), said conductor paths (40) being configured so that no scanning channel (10) is multiply connected to a circuit board test point.

13. Test apparatus as set forth in one of the claims 1 to 12,
**characterized in that**
for electrically connecting said electrical connections between said test connections and said circuit board test points a linking mask (50) is provided, said linking mask being arranged between an adapter (32) and a grid pattern (1), said linking mask (50) comprising conductor paths (57) electrically connecting at least two connecting elements such as e.g. probes (54; 54b) of said adapter (32) and/or connecting at least two connecting elements to a contact point (2)of said grid pattern.

14. Test apparatus as set forth in claim 13,
**characterized in that**
said linking mask (50) comprises holes (55) through which a portion of said probes (54) of said adapter (32) extend to make contact with said contact points (2) of said grid pattern (1).

15. Test apparatus as set forth in claim 13 or 14,
**characterized in that**
probes (54b) resting on said linking mask (50) are shorter than said probes (54a) extending through said holes (55), and during a first test procedure only said longer probes (54a) are in contact with said circuit board test points, and during a second test procedure all probes (54a, 54b) are in contact with said circuit board test points due to said board under test being urged, for instance, stronger.

16. Test apparatus as set forth in one of the claims 1 to 15,
**characterized in that**
a translator board (30) is provided, comprising on its surface contact pads (41o), each assigned to a circuit board test point, and comprising on the opposite surface contact pads (41 u), each assigned to a test connection, two of said contact pads (41o) assigned to circuit board test points being electrically connected together with a contact pad (41 u) assigned to a test connection.

17. Method for testing circuit boards for interrupts and schort-circuits by means of a test apparatus comprising an adapter
**characterized in that**
with the aid of at least one adjacency criterion it is established whether two circuits of said board under test can form practically no short-circuit, so that between these two circuits no short-circuit test needs to be done, and that a test apparatus as set forth in one of the claims 1 to 16 is used

18. Method for testing as set forth in claim 17,
**characterized in that**
at least the two circuits satisfying an adjacency criterion are electrically connected and are tested in common for a short circuit relative to at least one further circuit of a further array of circuits linked to each other.

19. Method as set forth in claim 17 or 18,
**characterized in that**
at least two circuits are electrically connected to each other in series and tested in common for an open circuit and/or short-circuit, a current being supplied merely to the ends of a series connection to establish whether one of said circuits connected in series has an open circuit.

20. Method as set forth in one of the claims 17 to 19,
**characterized in that**
for electrically connecting two circuits a linking mask (50) is used, arranged between an adapter (32) and a grid pattern (1), said linking mask (50) comprising conductor paths (57) electrically connecting at least two connecting elements such as e.g. the probes (54; 54b) of said adapter (32).

## Revendications

1. Appareil de test pour tester des cartes à circuits imprimés vis-à-vis de coupures et de courts-circuits, qui comprend un certain nombre de points de test de carte à circuits imprimés, comprenant :
une unité électronique d'évaluation qui comprend un certain nombre de bornes de test, chaque point de test d'une carte à circuit imprimé étant en contact via une liaison électrique avec une borne de test de l'unité électronique d'évaluation, et
au moins deux des liaisons électriques sont reliées électriquement l'une à l'autre de telle façon qu'au moins deux points de test de la carte à circuits imprimés à tester sont en liaison avec une unique borne de test,
**caractérisé en ce que**
les bornes de test de l'unité électronique d'évaluation sont reliées électriquement à une trame de base (1), un adaptateur (32) et/ou un convertisseur (30) étant agencé sur la trame de base (1) et une carte à circuit imprimé à tester peut être posée sur celui-ci, l'adaptateur (32) et/ou le convertisseur (30) établissant un contact électrique des points de test qui se trouvent sur la carte à circuits imprimés avec des emplacements de contact (2) de la trame de base (1),
**en ce que** la trame de base (1) est réalisée sur la surface d'une plaque de trame de base (3), au moins deux emplacements de contact (2) de la trame de base (1) étant reliés électriquement l'un à l'autre dans la plaque de trame de base (3),
**en ce que** la plaque de trame de base (3) est réalisée sous forme de carte à circuits imprimés stratifiée avec une couche de délimitation supérieure et une couche de délimitation inférieure (4, 5) et des couches intermédiaires (6),
**en ce que** des trous de contact (7) s'étendent depuis des emplacements de contact (2) verticalement vers le bas à travers les couches individuelles (4, 6) de la plaque de trame de base (3), les trous de contact (7) et les emplacements de contact (2) étant agencés dans une trame régulière, et
**en ce que** les trous de contact (7) et les emplacements de contact (2) sont agencés en plusieurs rangées, et entre les rangées de trous de contact entre deux couches intermédiaires respectives (6) s'étendent une paire de canaux de balayage (10), chaque canal de balayage (10) étant associé à la rangée voisine de trous de contact (7), et les trous de contact (7) étant reliés électriquement respectivement à un unique canal de balayage. (10) via une ligne de ramification (11) respective.

2. Appareil de test pour tester des cartes à circuit imprimé selon la revendication 1, **caractérisé en ce que** seuls les points de test de cartes à circuits imprimés de réseaux de la carte à circuits imprimés à tester qui remplissent un critère de relation adjacente sont reliés de façon électrique.

3. Appareil de test selon la revendication 2, **caractérisé en ce que** deux réseaux déterminés (42a-42e, 44) de la carte à circuits imprimés à tester remplissent un critère de relation adjacente lorsqu'un autre réseau (42b-42d) est agencé entre les deux réseaux.

4. Appareil de test selon la revendication 2 ou 3, **caractérisé en ce que** deux réseaux déterminés (42a-42e, 44) de la carte à circuits imprimés à tester remplissent un critère de relation adjacente lorsqu'à aucun emplacement la distance entre les deux réseaux est inférieure à une distance prédéterminée de relation adjacente.

5. Appareil de test selon l'une des revendications 2 à 4, **caractérisé en ce que** deux réseaux déterminés (42a-42e, 44) de la carte à circuits imprimés à tester remplissent un critère de relation adjacente lorsque les deux réseaux sont agencés dans des couches différentes de la carte à circuits imprimés à tester.

6. Appareil de test selon l'une des revendications 1 à 5, **caractérisé en ce que** les emplacements de contact (2) présentent une distance moyenne (a) de 100 µm à 1 mm et de préférence de 300 µm à 800 µm.

7. Appareil de test selon l'une des revendications 1 à 6, **caractérisé en ce que** chaque x-ième emplacement de contact (2) d'une rangée d'emplacements de contact (2) est relié électriquement au même canal de balayage (10), x étant un nombre entier entre 3 et 100 et de préférence entre 10 et 30.

8. Appareil de test selon l'une des revendications 1 à 6, **caractérisé en ce qu'**une interface électrique est agencée latéralement sur la plaque de trame de base (3) pour la mise en contact de l'unité électronique d'évaluation.

9. Appareil de test selon la revendication 8, **caractérisé en ce que** l'interface électrique est réalisée sous la forme de connecteur à enfichage.

10. Appareil de test selon l'une des revendications 1 à 9, **caractérisé en ce que** l'adaptateur (32) comprend des aiguilles qui se terminent chacune à un emplacement de contact (2), au moins une aiguille étant agencée en oblique par rapport à une ligne perpendiculaire à la trame de base.

11. Appareil de test selon l'une des revendications 1 à 10, **caractérisé en ce que** la carte de conversion (30) comporte des pistes conductrices (40) qui relient électriquement les points de test de la carte à circuits imprimés avec les emplacements de contact (2), les pistes conductrices (40) étant conçues de telle manière qu'aucun réseau de la carte à circuits imprimés à tester est relié plusieurs fois avec un canal de balayage (10).

12. Appareil de test selon l'une des revendications 1 à 11, **caractérisé en ce que** la carte de conversion (30) comporte des pistes conductrices (40) qui relient électriquement des points de test de la carte à circuits imprimés avec les emplacements de contact (2), les pistes conductrices (40) étant conçues de telle manière qu'aucun canal de balayage (10) est relié plusieurs fois avec un point de test de la carte à circuits imprimés.

13. Appareil de test selon l'une des revendications 1 à 12, **caractérisé en ce que** pour la connexion électrique des liaisons électriques entre les bornes de test et les points de test de la carte à circuits imprimés il est prévu un masque de chaînage (50) qui est agencé entre un adaptateur (32) et une trame de base (1), le masque de chaînage (50) comprenant des pistes conductrices (57) qui relient au moins trois éléments de liaison, comme par exemple des aiguilles (54 ; 54b), de l'adaptateur (32) sur le plan électrique, et/ou qui relient au moins trois éléments de liaison avec un emplacement de contact (2) de la trame de base.

14. Appareil de test selon la revendication 13, **caractérisé en ce que** le masque de chaînage (50) présente des trous (55) à travers lesquels s'étendent une partie des aiguilles (54) de l'adaptateur (32) pour venir en contact avec les emplacements de contact (2) de la trame de base (1).

15. Appareil de test selon la revendication 13 ou 14, **caractérisé en ce que** les aiguilles (54b) qui reposent sur le masque de chaînage (50) sont plus courtes que les aiguilles (54a) qui s'étendent à travers les trous (55), et pendant une première opération de mesure seules les aiguilles plus longues (54a) sont en contact avec les points de test de la carte à circuits imprimés, et pendant une seconde opération de mesure, toutes les aiguilles (54a, 54b) sont en contact avec des points de test de la carte à circuits imprimés puisque la carte à circuits imprimés à tester est par exemple plus fortement pressée.

16. Appareil de test selon l'une des revendications 1 à 15, **caractérisé en ce qu'**il est prévu une carte de conversion (30) qui présente sur une surface des surfaces de contact (41o) qui sont associées respectivement à un point de test de la carte à circuits imprimés, et sur la surface opposée des surfaces de contact (41u) qui sont respectivement associées à une borne de test, et deux des surfaces de contact (41o) associées aux points de test de la carte à circuits imprimés sont reliées électriquement conjointement avec une surface de contact (41u) associée à une borne de test.

17. Procédé pour tester des cartes à circuits imprimés vis-à-vis de coupures et de courts-circuits au moyen d'un appareil de test comportant un adaptateur, **caractérisé en ce que**, à l'aide d'au moins un critère de relation adjacente, on détermine si deux réseaux des cartes à circuits imprimés à tester ne peuvent pratiquement former aucun court-circuit, de sorte que l'on ne doit pas effectuer de test de court-circuit entre ces deux réseaux, et **en ce que** l'on utilise un appareil de test selon l'une des revendications 1 à 16.

18. Procédé pour tester des cartes à circuits imprimés selon la revendication 17, **caractérisé en ce que** au moins les deux réseaux qui remplissent un critère de relation adjacente sont reliés électriquement et sont testés conjointement vis-à-vis de courts-circuits par rapport à au moins un autre réseau ou un autre groupe de réseaux chaînés les uns avec les autres.

19. Procédé selon la revendication 17 ou 18, **caractérisé en ce qu'**au moins deux réseaux sont reliés électriquement l'un à l'autre dans un circuit série et sont testés conjointement vis-à-vis d'une coupure et/ou d'un court-circuit, dans lequel on injecte dans ce circuit série un courant uniquement aux extrémités du circuit série pour déterminer si l'un des réseaux branchés dans le circuit série présente une coupure.

20. Procédé selon l'une des revendications 17 à 19, **caractérisé en ce que** pour la liaison électrique de deux réseaux on utilise un masque de chaînage (50) qui est agencé entre un adaptateur (32) et une trame de base (1), le masque de chaînage (50) comportant des pistes conductrices (57) qui relient électriquement au moins deux éléments de liaison, comme par exemple des aiguilles (54 ; 54b) de l'adaptateur (32).
